# EUROPEAN PATENT APPLICATION

(11) **EP 1 484 428 A1**
(43) Date of publication of application: **08.12.2004**
(21) Application number: 04252749.9
(22) Date of filing: 12.05.2004
(51) Int. Cl.: C23C 14/08, C23C 14/02, C23C 14/14

(54) **A method of anodic oxidation of aluminium alloy films**

(30) Priority: 05.06.2003 US 454516
(71) Applicant: Maxford Technology Limited, Hong Kong (CN)
(72) Inventor: Chan, Winston Siu Yeung, Hong Kong (CN)
(74) Representative: Howe, Steven

(57) **Abstract**

A method of surface-treating a solid substrate (100, 200, 300) is disclosed as including the steps of (a) depositing a layer (102a, 202, 304) of aluminum-titanium alloy onto the substrate (100, 200, 300); and subsequently subjecting the substrate (100, 200, 300) to anodic oxidation. There is also disclosed an article including a solid substrate (100, 200, 300) and a matrix of aluminum oxide(s) and titanium oxide(s) thereon.

## Description

### Background of the Invention

In the consumer market, in addition to the functions of the products, aesthetic features also play an important role in capturing consumers' attention and promoting sale. Colours and metallic feel are two of such important aesthetic features. In general, products of plastics enclosures and casings are not perceived as of high value, in particular since they can be mass-produced. Metallic items, on the other hand, require extensive post-forming treatment, such as polishing, sandblasting, welding or joining. Furthermore, metallic articles or casings are sturdier and will not deform easily. Most important of all, such metallic items give the consumers a special feeling of touch.

Such metallic casings or articles may be made of such metals or alloys as aluminum and its alloys, copper and its alloys, stainless steel, magnesium alloys, and titanium alloys. Metallic casings or articles are usually regarded as the most premium, whereas stainless steel casings are the most widely used because various kinds of surface finishes can be made on stainless steel substrates. Aluminum and magnesium alloys are comparatively soft and lack in strength, and thus further support treatments are needed. As to copper and its alloys, such are easily tarnished, and so protective coatings are necessary.

Colouring can be effected on metallic surfaces by numerous methods. Colour paints, both solvent and water based, and pigments can be sprayed onto the surface of the metallic substrate, or dipped and then cured. There are a wide range of colours available for choice. However, there are the following associated drawbacks. Firstly, colour paints and pigments do not adhere well to metallic surface, and will peel off eventually. Secondly, the thickness of the layer of paint or pigment is normally over 15 microns, thus giving a plastic feel to the surface of the product, and therefore lowering the market value of such products.

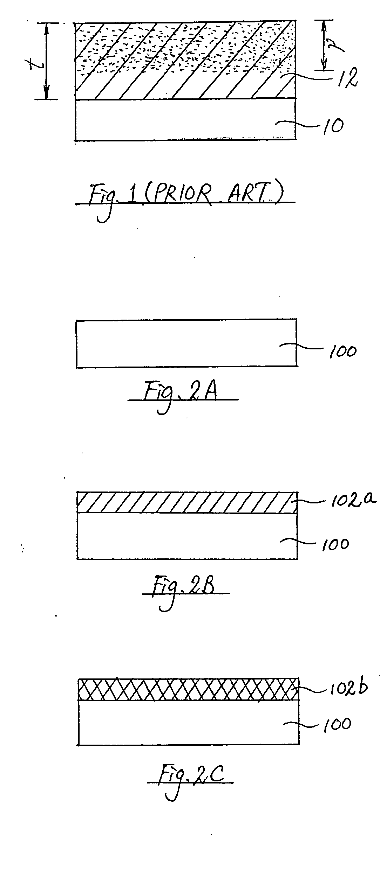

For aluminum alloys, colouring can be effected by first subjecting the items to anodic oxidation, and then to colour dyeing. An aluminum substrate treated in accordance with such a conventional method is shown in Fig. 1. Anodic oxidation of the aluminum substrate 10 converts the surface portion 12 into porous aluminum oxides, including, for example, Al₂O₃. The resultant surface portion 12 of aluminum oxides is further dyed to different colours. However, because of the porous nature of the aluminum oxides, much of the incident light is absorbed, therefore rendering the colour appearance lacking in brilliance and luster, thus rather dull. The colouring effect is also not permanent because the colour dyes can leach out. In addition, the dyes must penetrate to a depth d of over 10 microns into the substrate to achieve the colour effect. This would mean that the layer of aluminum oxides must also be of a thickness *t* of over 10 microns. As the layer of aluminum oxides 12 is much harder than the aluminum substrate 10, the mis-match in hardness will cause the layer of aluminum oxides 12 to crack if subjected to external stress.

Another shortcoming of this method is that such can only be practiced effectively on aluminum or aluminum alloys. For example, anodic oxidation cannot be carried out on stainless steel substrate. In the case of titanium substrates, only a very thin layer of soft titanium oxides, including, for example, titanium dioxide (TiO₂ is formed, because this surface layer of titanium oxides will prevent further oxidation.

Neither can anodic oxidation be satisfactorily performed on a polished aluminum surface, because the force exerted on such a surface during polishing changes the porosity of the aluminum substrates, which will cause uneven oxidation.

Simple monotonic colour effects can be obtained on metallic surface by electroplating and physical vapor deposition. For example, gold, silver and black chrome can be electroplated onto the surface of a metallic substrate to enhance its appearance. However, substances which are easily oxidized, e.g. aluminum and titanium, are not suitable for electroplating, because most oxides are not conductive, thus preventing or at least hindering further electroplating. On the other hand, by way of reactive physical vapor deposition (PVD), blue coating such as titanium carbo-oxide and brown coating such as titanium oxy-nitride can be deposited on a metal surface. One drawback of reactive PVD is the small process latitude, i.e. a small change in one of the process parameters will result in a substantial colour change. In addition, the variety of colours which can be obtained by reactive PVD is limited.

For plastic and glass substrates, electroplating is impossible as they are not electrically conductive. Colouring by reactive PVD can be realized on glass substrates, yet with limited choice of colours. Reactive PVD on plastic surfaces is not very feasible because most plastic substrates cannot withstand high temperature, yet reactive PVD is usually performed at a high temperature.

It is thus an object of the present invention to provide a method of surface-treating a solid substrate in which the aforesaid shortcomings are mitigated, or at least to provide a useful alternative to the public.

It is a further object of the present invention to provide a surface-treating method which is applicable on substrates made of a large variety of materials.

It is a yet further object of the present invention to provide a method of surface-treating a solid substrate in which the substrate can be coloured with a wide variety of colours, without using any pigments or dyes.

### Summary of the Invention

According to a first aspect of the present invention, there is provided a method of surface-treating at least one solid substrate, including the steps of (a) depositing a layer of an aluminum alloy including aluminum and at least a metal onto said substrate by physical vapor deposition; and (b) subjecting said substrate to anodic oxidation.

According to a second aspect of the present invention, there is provided an article including a solid substrate and a matrix of aluminum oxide(s) and oxide(s) of a metal on a surface thereof.

### Brief Description of the Drawings

Preferred embodiments of the present invention will now be described, by way of examples only, with reference to the accompanying drawings, in which:
Fig. 1 shows schematically a aluminum substrate treated in accordance with a conventional method;
Figs. 2A to 2C show schematically the steps whereby a method according to the present invention is carried out on a metal substrate;
Fig. 3 shows schematically a glass substrate treated by a method according to the present invention; and
Fig. 4 shows schematically a plastic substrate treated by a method according to the present invention.

### Detailed Description of the Preferred Embodiments

A method according to the present invention is applicable to a large variety of solid hard substrates, including glass, metals, metal alloys, and plastics. In particular, a method according to the present invention employs a combination of physical vapor deposition (PVD) and anodic oxidation. By way of simple PVD method, an aluminum alloy, i.e. an aluminum alloy including aluminum and at least one other metal, e.g. such refractory metals as titanium (Ti), zirconium (Zr), hafnium (Hf), vanadium (V), niobium (Nb) and tantalum (Ta), may first be deposited onto the surface of the substrate. The aluminum alloy contains at least 20 weight %, preferably at least 30 weight %, and more preferably at least 50 weight %, of aluminum. The layer of aluminum alloy is of a thickness of 0.5 to 20 microns, and preferably of a thickness of 1 to 10 microns. Subsequently, by anodic oxidation, this layer of aluminum alloy is then converted into oxides of aluminum, including e.g. Al₂O₃, and oxides of the other metal, e.g. TiO₂.

Colouring effects are realized by varying the electromotive force (emf)/voltage applied to the aluminum alloy coating during anodic oxidation. Traditional anodic oxidation of single-element aluminum substrate will form a transparent aluminum oxide layer, and its metallic look is due to reflection of light from the bottom surface. In contrast, in the present invention, the colouring effects are due to the interference effect of oxides of the other metal, e.g. TiO₂. Different electric voltages applied to the aluminum alloy coating causes differences in the thickness of oxides of the refractory metal so formed, and oxides the refractory metal of different thickness will create different colours because of interference effect. It can be seen that, in a method according to the present invention, no dyes or pigments are required for obtaining the colouring effects.

Normally, for a pure titanium substrate, only a very thin layer of soft titanium oxides is formed in anodic oxidation. The colours of the substrate so treated are very dull looking and not brilliant. In addition, as in the case of aluminum substrate, anodic oxidation of titanium can only be carried out on untreated or sandblasted surfaces, and not on polished surface, because cold work by polishing causes the titanium substrate to become denser and more compact, making the rate of anodic oxidation uneven, thus affecting the colouring effect. Furthermore, anodic oxidation of titanium is very superficial, meaning that the layer of titanium oxides is very thin and, since unprotected, will wear out quite easily.

It is a known fact that aluminum can be anodic oxidized to a thickness of the order of tens of microns. This is because the acidic solution used in aluminum oxidation also dissolves the surface layer of aluminum oxides while it oxidizes the underlying aluminum. This is also the reason why anodic aluminum oxide is porous. The present invention makes use of this porous aluminum oxide structure, which also allows the oxidation of the refractory metal into the bulk of the aluminum alloy substrate. The oxide of the refractory metal is formed in a matrix of aluminum oxide.

As aluminum oxide is very hard, it serves the purpose of protecting the relatively soft oxide of the refractory metal, which is responsible for the colouring effect because of interference of light. In addition, the aluminum oxide provides an overall hard coating such that the overall coating is of high wear resistance. For example, for a 2-micron Al/Ti oxide colour coating, i.e. with titanium being the refractory metal, the hardness is in excess of HV 300, under the Vicker's scale. For comparison purpose, the hardness of stainless steel is only about HV 200.

Optionally, minute quantities of nitrogen may be introduced into the aluminum alloy coating, for formation of titanium oxy-nitride (TiON) in the case of an aluminum-titanium alloy coating, which will create a slightly different colouring effect than pure titanium oxide. A wider spectrum of colours can thus be achieved.

Optionally, minute quantities of carbon may also be introduced into the aluminum alloy coating. In the case of an aluminum-titanium alloy layer, such will firstly enable the formation of titanium carbo-oxide (TiCO) which, like titanium oxy-nitride, provides a wide choice of colouring effects. Secondly, the carbon atoms are dispersed in the aluminum oxide/titanium oxide matrix, absorbing some of the light entering the matrix, thus adding subtlety and richness to the colours.

Minute quantities of carbon or nitrogen may be incorporated into the aluminum alloy coating by introducing a nitrogen-containing gas, e.g. nitrogen (N₂), or a hydrocarbon gas, e.g. acetylene (C₂H₂), during deposition of this layer of aluminum-titanium alloy coating. The quantities of the nitrogen or carbon may be varied by controlling the partial pressure of such gas when used, which may be kept at a partial pressure of from 4x10⁻⁵ torr to 6x10⁻⁵ torr (i.e. mmHg; equivalent to from around 5.332x10⁻³ Pa to 8.000x10⁻³ Pa).

Conventional anodic oxidized aluminum, containing e.g. Al₂O₃, is very hard, and cannot therefore match well with the soft aluminum substrate. In addition, if the aluminum oxide/aluminum structure is subjected to an outside stress, e.g. when the structure is bent to around 90°, the aluminum oxide will crack. In a solid substrate surface-treated in accordance with a method according to the present invention, a matrix of hard aluminum oxide and soft oxide of, e.g. a refractory metal will form, creating a buffering effect, and rendering the coating very resilient. Experiments indicate that after an aluminum substrate coated with a 3-micron aluminum oxide/titanium oxide coating has been subjected to bending of 90° or even 180° for over 50 times, no crack or crevice was evident upon observation via a 100x microscope. The present invention can thus be applied on substrates of all shaped forms.

Below are some methods of carrying out the present invention.

### Example 1

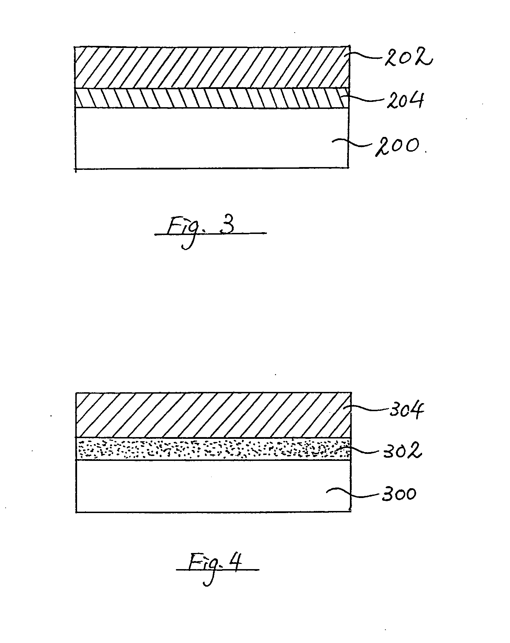

Referring to Figs. 2A to 2C, titanium substrates, of which one is shown in Fig. 2A, and generally designated as 100, were de-waxed and cleaned with a solvent in supersonic containers.

By way of a physical vapor deposition (PVD) method, e.g. DC sputtering, multi-arc plasma deposition or evaporation, a layer of aluminum-titanium alloy coating 102a of a thickness of 1-10 microns was deposited onto the titanium substrate 100, as shown in Fig. 2B. The coating layer is composed principally of aluminum, i.e. of over 50 weight % of aluminum, with the rest being titanium.

The apparatus for subsequent anodic oxidation includes a container made of an electrically non-conducting material, e.g. ceramic or plastics, an un-interrupted DC power supply, and fixtures made of titanium or titanium alloys. The DC power supply had an input voltage of 220 volts, and an adjustable output of between 0-110 volts. The Al/Ti coating constituted the anode in this apparatus, and the cathode was made of stainless steel. The ratio of the surface area of the cathode and the surface area of the anode was between 1:1 to 10:1; the bigger the ratio is, the more uniform the colouring effect is.

The electrolytic solution for anodic oxidation included phosphoric acid, sulphuric acid and oxalate salts, with the pH value adjusted as between 1-2. Anodic oxidation was carried out at room temperature and took 5 to 20 minutes, depending on the loading of the substrates, and a matrix of hard aluminum oxides and soft titanium oxides 102b was formed. Different colours could be obtained by adjusting the voltage applied to the Al/Ti alloy layer, which constituted the anode, as listed in the following Table 1:

**Table 1**

| Colour | Voltage (volts) |
|---|---|
| Burgundy | 18-22 |
| Dark blue | 24-26 |
| Royal blue | 28-32 |
| Bright blue | 34-36 |
| Pale blue | 38-42 |
| Blue grey | 44-46 |
| Pale yellow | 48-52 |
| Light yellow | 54-56 |
| Golden yellow | 58-62 |
| Deep yellow | 64-66 |
| Yellow red | 68-72 |
| Rose red | 74-76 |
| Red | 78-82 |
| Violet | 84-86 |
| Rosy violet | 88-92 |
| Blue violet | 94-96 |
| Blue purple | 98-102 |
| Blue green | 104-106 |
| Green | 108-111 |

It is believed that more colours could be developed if the output voltage could be further upwardly adjusted.

### Example 2

For metal or metal alloy substrates, e.g. stainless steel substrate, the treatment procedure was almost the same as in Example 1 above, except that the stainless steel substrate, e.g. watch casing, or watch bracelet, was completed coated/deposited with a layer of aluminum/titanium alloy. For parts of the substrate on which no coating is intended, an insulating substance, e.g. lacquer, was applied before anodic oxidation. This was required as stainless steel is much more electrically conductive, so that stainless steel regions will draw most of the electric current, thus hindering the anodic oxidation process. The relationship between colour effects and voltage is the same as that detailed in Table 1 above.

### Example 3

For glass substrate or glass surface, the treatment procedure was very similar to that discussed in Example 1 above, except that, referring to Fig. 3, in order to enhance the adhesion of a layer 202 of aluminum-titanium alloy onto the glass surface 200, an thin interfacial layer 204 of chromium (Cr) was first deposited onto the glass surface 200, also by a physical vapor deposition method. The interfacial chromium layer 204 is of a thickness of less than 500Å.

### Example 4

The present invention can also be practiced on plastics materials, including, e.g. acrylic, polycarbonate, or a combination thereof. As most plastics surfaces or plastics articles cannot withstand high temperature, say over 100°C, a low temperature process was adopted for the deposition of an aluminum-titanium alloy coating onto the plastics substrate or plastics surface.

Referring in particular to Fig. 4, a plastics substrate 300 made of, e.g. a combination of acrylic and polycarbonate, was further coated with a layer 302 a silicon-containing polymer to act as an interfacial layer between the substrate 300 and the aluminum-titanium alloy layer 304. This polymeric layer 302, of a thickness of around 3 microns, was coated onto the substrate 300 by spraying/dipping and curing, as in the conventional manner. An appropriate silicon-containing polymer for this purpose may be one traded under the trade mark ESSCON® G-MRI by Luvantix Co., Ltd., of Ansan, South Korea. The anodic oxidation process was the same as that described in Example 1 above.

It can be seen that a surface-treatment method according to the present application can be applied on a large number of articles, including, e.g. watches, jewelry items, mobile phones, eyeglass frames and lenses, etc. It should be noted that although the invention has thus far been discussed in the context of deposition and anodic oxidation of a layer of an aluminum-titanium alloy, such a method is equally applicable on the deposition and anodic oxidation of an aluminum-zirconium alloy, aluminum-vanadium alloy, aluminum-hafnium alloy, aluminum-niobium alloy and aluminum-tantalum alloy, for surface-treating a solid substrate.

It should be understood that the above only illustrates examples whereby the present invention may be carried out, and that various modifications and/or alterations may be made thereto without departing from the spirit of the invention.

It should also be understood that certain features of the invention, which are, for clarity, described in the context of separate embodiments, may be provided in combination in a single embodiment. Conversely, various features of the invention which are, for brevity, described in the context of a single embodiment, may also be provided separately or in any appropriate sub-combinations.

## Claims

1. A method of surface-treating at least one solid substrate, including the steps of:
(a) depositing a layer of an aluminum alloy including aluminum and at least a metal onto said substrate by physical vapor deposition; and
(b) subjecting said substrate to anodic oxidation.

2. A method according to Claim 1 wherein said step (b) is carried out after said step (a) whereby said layer of aluminum alloy is anodic oxidized to form a matrix of at least aluminum oxide(s) and oxide(s) of said metal.

3. A method according to Claim 1 wherein said layer of aluminum alloy is of a thickness of from substantially 0.5 to 20 microns.

4. A method according to Claim 3 wherein said layer of aluminum alloy is of a thickness of from substantially 1 to 10 microns.

5. A method according to Claim 1 wherein said layer of aluminum alloy contains at least 20 weight % of aluminum.

6. A method according to Claim 5 wherein said layer of aluminum alloy contains at least 30 weight % of aluminum.

7. A method according to Claim 5 wherein said layer of aluminum alloy contains at least 50 weight % of aluminum.

8. A method according to Claim 1 wherein in said step (b), said substrate acts as the anode.

9. A method according to Claim 1 wherein in said step (b), the ratio of the surface area of the cathode and the surface area of the anode is between substantially 1:1 to substantially 10:1.

10. A method according to Claim 1 wherein said substrate is made at least principally of a metal, a metal alloy, glass or plastics.

11. A method according to Claim 1 including a step (c) of depositing at least one interfacial layer onto said substrate.

12. A method according to Claim 11 wherein said step (c) is carried out before said step (a) and step (b).

13. A method according to Claim 11 wherein said interfacial layer comprises at least principally of chromium.

14. A method according to Claim 13 wherein said layer of chromium is of a thickness of less than 500Å.

15. A method according to Claim 11 wherein said interfacial layer comprises at least principally of a silicon-containing polymer.

16. A method according to Claim 1 wherein said metal is a refractory metal.

17. A method according to Claim 1 wherein said metal is titanium, zirconium, vanadium, hafnium, niobium or tantalum.

18. An article including a solid substrate and a matrix of aluminum oxide(s) and oxide(s) of a metal on a surface thereof.

19. An article according to Claim 18 wherein said matrix is of a thickness of substantially 0.5 to 20 microns.

20. An article according to Claim 18 wherein said matrix is of a thickness of substantially 1 to 10 microns.

21. An article according to Claim 18 wherein said substrate is made at least principally of a metal, a metal alloy, glass or plastics.

22. An article according to Claim 18 further including an interfacial layer between said matrix and said substrate.

23. An article according to Claim 22 wherein said interfacial layer comprises at least principally of chromium.

24. An article according to Claim 23 wherein said layer of chromium is of a thickness of less than 500Å.

25. An article according to Claim 22 wherein said interfacial layer comprises at least principally of a silicon-containing polymer.

26. An article according to Claim 18 wherein said metal is a refractory metal.

27. An article according to Claim 18 wherein said metal is titanium, zirconium, vanadium, hafnium, niobium or tantalum.
